# FASCICULE DE BREVET EUROPEEN

(11) **EP 1 846 588 B1**
(45) Date de publication et mention de la délivrance du brevet: **04.08.2010**
(21) Numéro de dépôt: 06709475.5
(22) Date de dépôt: 03.02.2006
(51) Int. Cl.: C23C 14/34, C23C 14/06

(54) **PROCÉDÉ D'ÉLABORATION PAR PROJECTION THERMIQUE D'UNE CIBLE À BASE DE SILICIUM ET DE ZIRCONIUM**
VERFAHREN ZUR HERSTELLUNG EINES SILICIUM- UND ZIRCONIUMBASIERTEN TARGETS DURCH THERMISCHES SPRÜHEN
METHOD FOR PREPARING BY THERMAL SPRAYING A SILICON- AND ZIRCONIUM-BASED TARGET

(30) Priorité: 08.02.2005 FR 0550358
(43) Date de publication de la demande: 24.10.2007
(73) Titulaire: SAINT-GOBAIN GLASS FRANCE, 92400 Courbevoie (FR)
(72) Inventeur: NADAUD, Nicolas, F-94250 Gentilly (FR); BILLIERES, Dominique, 1, Lotissement du Moulin, F-84450 Saint Saturnin les Avignon (FR)
(74) Mandataire: Colombier, Christian
(86) Numéro de dépôt international: PCT/FR2006/050094
(87) Numéro de publication internationale: WO 2006/085020

(56) Documents cités:
- EP-A- 0 436 741
- EP-A- 0 666 336
- US-A- 5 354 446
- US-A1- 2002 119 378
- US-A1- 2003 103 857
- PEREZ P ET AL: "Oxidation behaviour of Al-alloyed ZrSi2 at 700<o>C" INTERMETALLICS, ELSEVIER SCIENCE PUBLISHERS B.V, GB, vol. 8, no. 12, décembre 2000 (2000-12), pages 1393-1398, XP004223358 ISSN: 0966-9795
- PILLOUD D ET AL: "Structural changes in Zr-Si-N films vs. their silicon content" SURFACE & COATINGS TECHNOLOGY ELSEVIER SWITZERLAND, vol. 180-181, 1 mars 2004 (2004-03-01), pages 352-356, XP002386022 ISSN: 0257-8972
- NOSE M ET AL: "Microstructure and mechanical properties of Zr-Si-N films prepared by rf-reactive sputtering" JOURNAL OF VACUUM SCIENCE AND TECHNOLOGY A. VACUUM, SURFACES AND FILMS, AMERICAN INSTITUTE OF PHYSICS, NEW YORK, NY, US, vol. 20, no. 3, mai 2002 (2002-05), pages 823-828, XP012006073 ISSN: 0734-2101
- ZHOU M ET AL: "Influence of sputtering conditions on microstructure and mechanical properties of Zr-Si-N films prepared by radio-frequency-reactive sputtering*" JOURNAL OF VACUUM SCIENCE AND TECHNOLOGY A. VACUUM, SURFACES AND FILMS, AMERICAN INSTITUTE OF PHYSICS, NEW YORK, NY, US, vol. 21, no. 5, septembre 2003 (2003-09), pages 1791-1795, XP012006536 ISSN: 0734-2101

## Description

La présente invention concerne un procédé d'élaboration d'une cible destinée à être utilisée dans les procédés de dépôt sous vide, en atmosphère neutre ou réactive, notamment par pulvérisation cathodique assistée par champ magnétique, par pulvérisation ou par source d'ions.

Selon un autre aspect de l'invention, elle vise également une cible obtenue par la mise en oeuvre dudit procédé, ainsi que l'utilisation d'une telle cible en vue de l'obtention de couches à base du matériau pulvérisé à partir de ladite cible, ainsi qu'une composition du composé permettant l'élaboration de ladite cible par le procédé objet de l'invention.

On connaît diverses techniques conduisant à la fabrication de cibles à partir de la mise en forme d'un mélange de poudres. Ainsi, les cibles en question peuvent résulter d'un processus de fonderie, de frittage dudit mélange, ou moins classiquement d'une technique de projection thermique, et plus particulièrement d'une technique de projection par torche plasma (ou communément appelée plasma spray en anglais).

Les techniques de projection thermique donnent satisfaction tant qu'il s'agit d'élaborer des cibles mono constituant, mais lorsque la cible est à base de plusieurs constituants, la cible présente généralement des hétérogénéités structurelles qui conduisent à des inhomogénéités au niveau de la couche déposée.

Plus particulièrement, les inventeurs ont constaté que pour des mélanges de poudres présentant des densités sensiblement différentes, par exemple un mélange à base de poudres comprenant du silicium (densité= 2,34), de l'aluminium (densité=2,7) et un autre constituant M dont la densité peut être comprise entre 5 et 10, les écarts de densité entre Si, A1 d'une part et M d'autre part, induisent les problèmes suivants :
- risque de ségrégation et donc d'hétérogénéité dans le mélange de poudre avant injection conduisant finalement à une cible inhomogène en composition
- trajectoires différentes de chacune des espèces dans la veine plasma pour les poudres de densité différentes, conduisant à la séparation du faisceau de particules en autant de faisceaux qu'il y a de niveaux de densité différents (respectivement autant de faisceau qu'il y a d'espèce ou de constituant dans le mélange). Ces faisceaux distincts conduisent alors à des hétérogénéités de microstructure dans la cible, la microstructure étant alors de type multi-couche (superposition de couches A et B.

Ces hétérogénéités dans la cible induisent des effets négatifs lors de la réalisation des couches minces par pulvérisation (phénomène d'arcs parasites, hétérogénéité des compositions des couches minces). Cela peut également produire une augmentation de rugosité de la surface de la cible consécutive au gradient de rendement de pulvérisation des différentes zones au sein de la cible. Cette augmentation de rugosité peut se traduire dans les cas extrêmes par l'apparition de protubérances de taille significative (qq mm en diamètre/hauteur) conduisant à l'apparition d'arcs en surface (exacerbation du champ électrique par effet de pointe).

En outre, certaines espèces qui doivent être mélangées aux constituants présentent des risques industriels élevés surtout lorsqu'elles sont présentes sous forme de métaux purs pulvérulents (grande surface spécifique) dans des gammes de granulométrie requises pour la projection plasma (risque d'explosion pour certains métaux pulvérulents du fait de leur extrême avidité en oxygène).

La présente invention vise donc à pallier ces inconvénients en proposant un procédé d'élaboration de cibles par projection thermique, notamment par voie plasma qui permette l'obtention de cible à microstructure homogène, malgré la disparité des densités respectives de chacune des espèces constituant le mélange initial.

L'invention vise selon un premier aspect une composition d'un composé comprenant les constituants définis ci-après et exprimés en pourcentages massique, permettant l'élaboration d'une cible, caractérisée en ce qu'elle est constituée essentiellement de:
- Al : 2 à 20%
- Si : 25 à 45%
- ZrSi₂ : 45 à 70%

A cet effet, l'invention se rapporte à un procédé d'élaboration, par projection thermique, notamment par voie plasma, d'une cible, ladite cible comprenant au moins un composé répondant à la composition précédente, dans lequel on injecte au moins une fraction dudit composé dont les constituants sont liés par liaisons covalentes et/ou ioniques et/ou métalliques dans un propulseur plasma, ledit propulseur plasma projetant les constituants dudit composé sur la cible de manière à obtenir un dépôt dudit composé au niveau d'une portion de surface de ladite cible.

Grâce à l'injection d'un composé de type alliage (ou présentant un mélange intime des atomes) dans la veine plasma, il n'y a plus de risque d'hétérogénéité entre les atomes constitutifs dudit composé au niveau du matériau déposé.

Dans des modes de réalisation préférés de l'invention, on peut éventuellement avoir recours en outre à l'une et/ou à l'autre des dispositions suivantes :
- on injecte une autre fraction dudit composé sous forme d'un mélange de poudres,
- on adapte la granulométrie de chacune des poudres formant le mélange en fonction de leur densité respective de manière à ce que leur masse moyenne respective soit aussi proche que possible,
- on utilise plusieurs canaux d'injection pour lesquels on ajuste indépendamment les paramètres d'injection en fonction des matériaux injectés dans chaque canal,
- la projection du composé est réalisée au sein d'une enceinte remplie d'une atmosphère neutre après une purge préalable par mise au vide,
- la projection du composé est réalisée au sein d'une enceinte ayant été purgée sous vide puis remplie d'un gaz neutre, jusqu'à une pression pouvant aller de 50 mbars à 1000 mbars.
- on réalise un mouvement relatif entre la cible et le plasma,
- on réalise un traitement de surface de la cible préalablement au dépôt dudit composé,
- le traitement de surface comporte un nettoyage de la portion de surface de la cible,
- le traitement de surface comporte un dépôt d'une couche d'un matériau d'accrochage au niveau de la portion de surface de la cible,
- on procède à une régulation thermique de la portion de surface de la cible lors de la projection plasma,
- on injecte au moins un siliciure dudit métal M,

Selon un autre aspect de l'invention, celle-ci vise une cible de dispositif de pulvérisation cathodique, notamment assistée par champ magnétique, ladite cible comprenant majoritairement du silicium et étant caractérisée en ce que sa composition répond à la composition précédemment décrite.

Dans des modes de réalisation préférés de l'invention, on peut éventuellement avoir recours en outre à l'une et/ou à l'autre des dispositions suivantes :
- la cible comporte également un composé de type siliciure dudit métal,
- la cible est de géométrie plane ou tubulaire,
- la cible est à base d'un matériau support en cuivre ou alliage cuivreux,
- la cible est revêtue d'une couche d'accrochage à base d'un alliage cuivreux,
- la cible est à base d'un matériau support en acier inoxydable,
- la cible est revêtue d'une couche d'accrochage à base d'un alliage de nickel,

D'autres caractéristiques et avantages de l'invention apparaîtront au cours de la description suivante donnée à titre d'exemples non limitatifs, illustrée par les figures suivantes :
- la figure 1 est une vue montrant la microstructure en coupe d'une cible SiZrNAl obtenue par le procédé d'élaboration selon l'invention,
- la figure 2 est une vue montrant la microstructure en coupe d'une cible ZrSi₂Al obtenue par le procédé d'élaboration selon l'invention,
- la figure 3 est une vue montrant la microstructure en coupe d'une cible ZrSiAl obtenue par un procédé d'élaboration traditionnel (par frittage).

Selon un mode préféré d'élaboration d'une cible objet de l'invention, celle-ci comporte un support cylindrique ou plan en alliage cuivreux ou en acier inoxydable.
Ce support métallique subit un traitement de surface qui consiste essentiellement en un nettoyage par projection surface par projection de grains abrasifs (grit 36 ou 24 par exemple) ou par réalisation de rayures ou stries par usinage afin de favoriser l'adhérence d'une sous-couche d'accrochage.

En fonction de la nature du matériau formant le support de la cible, on différenciera le matériau de cette sous-couche d'accrochage. Ainsi, pour un support en acier, la sous-couche est réalisée en alliage à base de Ni (par exemple NiAl avec Ni 75 à 100% en proportion massique) tandis que pour une plaque support à base de cuivre, la sous-couche est un alliage à base de cuivre, par exemple de type Cu-Al-Fe ou Cu-Al (80 à 95% de Cu - et 5 à 20% de Al - et 0 à 5% de Fe ), les proportions exprimées étant massiques.

Cette sous-couche peut être déposée par une technique classique de projection plasma. Il est aussi possible de l'appliquer par projection à l'arc électrique ou à la flamme oxyacéthylénique. Au besoin, on utilise plusieurs canaux d'injection pour lesquels on ajuste indépendamment les paramètres d'injection en fonction des matériaux injectés dans chaque canal, ceci permettant également d'annuler les effets négatifs des disparités de densité.

Ce support ainsi revêtu d'une sous-couche d'accrochage est installée dans une enceinte, initialement tirée au vide et postérieurement remplie d'une atmosphère neutre (argon par exemple) sous une pression de 50 à 1000 mbars.

Après mise en mouvement relatif le support destiné à constituer la cible par rapport au dispositif de projection par plasma et régulation thermique par une circulation d'un fluide caloporteur au niveau du support métallique, on injecte un composé de composition SiZrAl obtenue à partir d'un mélange de poudres de composition
- ZrSi₂ - granulométrie 15-50 µm - Densité ZrSi₂ = 4,88 g/cm³
- Si - granulométrie 30-90 µm - Densité Si = 2,34 g/cm³
- Al - granulométrie 45-75 µm - Densité Al = 2,7 g/cm³

Les 3 poudres ont été mélangées dans les proportions requises, soit :
- 60% massiques de ZrSi₂
- 34,5% massiques de Si
- 5,5% massiques de Al

Dans cet exemple le métal M choisi qui est lié au silicium sous forme de siliciure est du zirconium, mais il est bien entendu qu'on aurait pu utiliser un constituant sous forme d'un métal M choisi parmi (Zr, Mo, Ti, Nb, Ta, Hf, Cr).

La couche fonctionnelle Si-M-Al présente une microstructure constituée d'une juxtaposition de zones dont la composition est majoritairement Si et de zones de composition MₐSi_{b} et de zones de composition Al, réparties de façon homogène, la taille de ces zones étant de quelques microns à environ 100 microns.

Cette cible est particulièrement destinée à être utilisée au sein d'une installation de dépôt de dépôt de couche sous vide (magnétron en atmosphère neutre ou réactive, notamment par pulvérisation cathodique assistée par champ magnétique, par décharge couronne, ou par pulvérisation par source ionique) , en vue de l'obtention d'une couche à base du matériau formant ladite cible, cette couche étant à base d'un nitrure mixte de silicium et de zirconium, et dont l'indice de réfraction est compris entre 2,10 et 2,30, préférentiellement entre 2,15 et 2,25. Cette couche est destinée à être liée (c'est-à-dire déposée directement sur un substrat ou indirectement sur une autre couche elle même en contact d'un substrat) à un substrat en matière organique (PMMA, PC) ou inorganique (verre à base de silice).

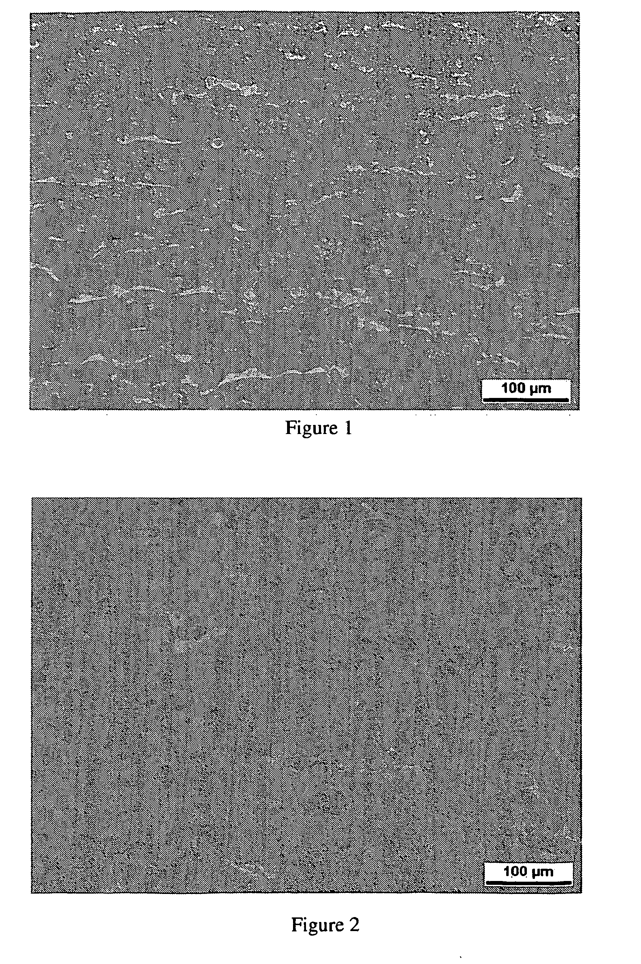

Comme on peut le voir sur les figures 1 et 2, on constate que la structure est lamellaire. Des strates de couleur blanche ou gris clair correspondent à l'aluminium tandis que la phase de couleur grise plus foncée correspond au ZrSi₂ ou au ZrN. Les tâches noires sont la porosité résiduelle.

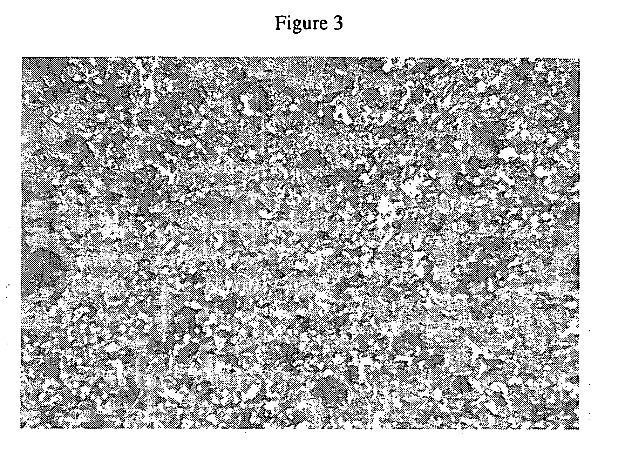

La microstructure lamellaire de ces figures sont à comparer à celle représentée en figure 3. Comme le montre cette figure 3, la microstructure n'est pas du tout lamellaire (il n'y a pas de strates de couleur ou grise), la phase grise est du Si, alors que la phase noire correspond aux porosités et les phases blanches sont Zr et Al. Les matériaux apparaissent sous forme de particules uniformément réparties dans la structure.

En conclusion à ces analyses qualitatives, il est tout à fait possible, à partir d'une microstructure, de caractériser le procédé d'élaboration de la cible ainsi analysée.

## Revendications

1. Composition d'un composé comprenant les constituants définis ci-après et exprimés en pourcentage massique, permettant l'élaboration d'une cible par un procédé d'élaboration par projection thermique, notamment par voie plasma, **caractérisée en ce qu'**elle est constituée essentiellement de :
- Al : 2 à 20%
- Si : 25 à 45%
- ZrSi₂ : 45 à 70%

2. Composition selon la revendication 1, **caractérisée en ce qu'**elle est obtenue à partir d'un mélange de poudres dont les granulométries respectives sont les suivantes :
- la granulométrie du ZrSi₂ est comprise entre 15-50 µm
- la granulométrie du Si est comprise entre 30-90 µm
- la granulométrie de Al est comprise entre 45-75 µm

3. Procédé d'élaboration par projection thermique, notamment par voie plasma, d'une cible, ladite cible comprenant au moins un composé à base d'atomes de nature différente selon la composition selon l'une des revendications 1 ou 2, **caractérisé en ce qu'**on injecte au moins une fraction dudit composé dont les constituants sont liés par liaisons covalentes et/ou ioniques et/ou métalliques dans un propulseur plasma, ledit propulseur plasma projetant les constituants dudit composé sur la cible de manière à obtenir un dépôt dudit composé au niveau d'une portion de surface de ladite cible

4. Procédé selon la revendication 3, **caractérisé en ce qu'**on injecte une autre fraction dudit composé sous forme d'un mélange de poudres.

5. Procédé selon l'une des revendications 3 ou 4, **caractérisé en ce qu'**on adapte la granulométrie de chacune des poudres formant le mélange en fonction de leur densité respective de manière à ce que leur masse moyenne respective soit aussi proche que possible.

6. Procédé selon l'une quelconque des revendications 3 à 5, **caractérisé en ce que** la projection du composé est réalisée au sein d'une enceinte remplie d'une atmosphère neutre.

7. Procédé selon la revendication 6, **caractérisé en ce que** la projection du composé est réalisée au sein d'une enceinte ayant été purgée sous vide puis remplie d'un gaz neutre, jusqu'à une pression pouvant aller de 50 mbars à 1000 mbars.

8. Procédé selon l'une quelconque des revendications 3 à 7, **caractérisé en ce qu'**on réalise un mouvement relatif entre la cible et le plasma.

9. Procédé selon l'une quelconque des revendications 3 à 8, **caractérisé en ce qu'**on réalise un traitement de surface de la cible préalablement au dépôt dudit composé.

10. Procédé selon la revendication 9, **caractérisé en ce que** le traitement de surface comporte un nettoyage de la portion de surface de la cible.

11. Procédé selon la revendication 9, **caractérisé en ce que** le traitement de surface comporte un dépôt d'une couche d'un matériau d'accrochage au niveau de la portion de surface de la cible.

12. Procédé selon l'une quelconque des revendications 3 à 11, **caractérisé en ce qu'**on procède à une régulation thermique de la portion de surface de la cible lors de la projection plasma dudit composé.

13. Procédé selon l'une quelconque des revendications 3 à 12, **caractérisé en ce qu'**on utilise plusieurs canaux d'injection pour lesquels on ajuste indépendamment les paramètres d'injection en fonction des matériaux injectés dans chaque canal.

14. Cible de dispositif de pulvérisation cathodique, notamment assistée par champ magnétique, ladite cible étant de composition selon l'une des revendications 1 ou 2.

15. Cible selon l'une des revendications 14, **caractérisée en ce qu'**elle est de géométrie plane ou tubulaire.

16. Cible selon l'une des revendications 14 ou 15 **caractérisée en ce qu'**elle est à base d'un matériau support en cuivre ou alliage cuivreux.

17. Cible selon la revendication 16, **caractérisée en ce que** la cible est revêtue d'une couche d'accrochage à base d'un alliage cuivreux.

18. Cible selon l'une des revendications 14 ou 15, **caractérisée en ce qu'**elle est à base d'un matériau support en acier inoxydable.

19. Cible selon la revendication 18, **caractérisée en ce que** la cible est revêtue d'une couche d'accrochage à base d'un alliage de nickel.

## Claims

1. Composition of a compound comprising the constituents defined below and expressed in percentages by weight, for producing a target using a method of production by thermal spraying, especially by plasma spraying, **characterized in that** it essentially consists of:
- Al: 2 to 20%;
- Si: 25 to 45%; and
- ZrSi₂: 45 to 70%.

2. Composition according to Claim 1, **characterized in that** it is obtained from a powder blend, the respective particle sizes of which are the following:
- the ZrSi₂ particle size is between 15 and 50 µm;
- the Si particle size is between 30 and 90 µm; and
- the Al particle size is between 45 and 75 µm.

3. Method of producing a target by thermal spraying, especially by plasma spraying, said target comprising at least one compound based on atoms of different types according to the composition according to either of Claims 1 and 2, **characterized in that** at least one fraction of said compound, the constituents of which are bonded by covalent and/or ionic and/or metallic bonds, is injected into a plasma jet, said plasma jet spraying the constituents of said compound onto the target so as to deposit a coating of said compound on a surface portion of said target.

4. Method according to Claim 3, **characterized in that** another fraction of said compound in the form of a powder blend is injected.

5. Method according to either of Claims 3 and 4, **characterized in that** the particle size of each of the powders forming the blend is adapted according to their respective density so that their respective mean masses are as close as possible.

6. Method according to any one of Claims 3 to 5, **characterized in that** the compound is sprayed in a chamber filled with an inert atmosphere.

7. Method according to Claim 6, **characterized in that** the compound is sprayed in a chamber that has been vacuum-purged and then filled with an inert gas, for pressure that may range from 50 mbar to 1000 mbar.

8. Method according to any one of Claims 3 to 7, **characterized in that** a relative movement between the target and the plasma is performed.

9. Method according to any one of Claims 3 to 8, **characterized in that** the target undergoes a surface treatment prior to the deposition of said compound.

10. Method according to Claim 9, **characterized in that** the surface treatment comprises a cleaning operation carried out on the surface portion of the target.

11. Method according to Claim 9, **characterized in that** the surface treatment comprises the deposition of a layer of a tie material on the surface portion of the target.

12. Method according to any one of Claims 3 to 11, **characterized in that** the surface portion of the target is thermally regulated during the plasma spraying of said compound.

13. Method according to any one of Claims 3 to 12, **characterized in that** several injection channels are used, in which the injection parameters are independently adjusted according to the materials injected into each channel.

14. Sputtering target, especially a magnetron sputtering target, said target having the composition according to either of Claims 1 and 2.

15. Target according to Claim 14, **characterized in that** it has a plane or tubular geometry.

16. Target according to either of Claims 14 and 15, **characterized in that** it is based on a support material made of copper or a copper alloy.

17. Target according to Claim 16, **characterized in that** it is coated with a tie layer based on a copper alloy.

18. Target according to either of Claims 14 and 15, **characterized in that** it is based on a support material made of stainless steel.

19. Target according to Claim 18, **characterized in that** it is coated with a tie layer based on a nickel alloy.

## Patentansprüche

1. Zusammensetzung einer die nachfolgend definierten und in Masseprozent ausgedrückten Bestandteile umfassenden Verbindung, welche die Herstellung eines Targets mittels eines Verfahrens zur Herstellung durch thermisches Spritzen, insbesondere Plasmaspritzen ermöglicht, **dadurch gekennzeichnet, dass** sie im Wesentlichen aus folgendem besteht:
- Al: 2 bis 20 %
- Si: 25 bis 45 %
- ZrSi₂: 45 bis 70 %.

2. Zusammensetzung nach Anspruch 1, **dadurch gekennzeichnet, dass** sie aus einem Gemisch von Pulvern erhalten wird, deren jeweilige Korngrößen folgende sind:
- die Korngröße von ZrSi₂ liegt zwischen 15 und 50 µm
- die Korngröße von Si liegt zwischen 30 und 90 µm
- die Korngröße von Al liegt zwischen 45 und 75 µm.

3. Verfahren zur Herstellung eines Targets durch thermisches Spritzen, insbesondere Plasmaspritzen, wobei das Target wenigstens eine Verbindung auf der Basis von Atomen unterschiedlicher Art entsprechend der Zusammensetzung nach einem der Ansprüche 1 oder 2 umfasst, **dadurch gekennzeichnet, dass** wenigstens ein Teil der Verbindung, deren Bestandteile durch kovalente und/oder ionische und/oder metallische Bindungen verbunden sind, in eine Plasmatreibvorrichtung eingespritzt wird, wobei die Plasmatreibvorrichtung die Bestandteile der Verbindung auf das Target aufspritzt, so dass eine Abscheidung der Verbindung im Bereich eines Oberflächenabschnitts des Targets erhalten wird.

4. Verfahren nach Anspruch 3, **dadurch gekennzeichnet, dass** ein weiterer Teil der Verbindung in Form eines Pulvergemischs eingespritzt wird.

5. Verfahren nach einem der Ansprüche 3 oder 4, **dadurch gekennzeichnet, dass** die Korngröße eines jeden der das Gemisch bildenden Pulver in Abhängigkeit ihrer jeweiligen Dichte angepasst wird, so dass ihre jeweilige durchschnittliche Masse möglichst nahe ist.

6. Verfahren nach einem der Ansprüche 3 bis 5, **dadurch gekennzeichnet, dass** das Spritzen der Verbindung innerhalb eines mit neutraler Atmosphäre gefüllten Raumes durchgeführt wird.

7. Verfahren nach Anspruch 6, **dadurch gekennzeichnet, dass** das Spritzen der Verbindung innerhalb eines Raumes durchgeführt wird, der unter Vakuum entleert, anschließend bis zu einem Druck, der von 50 mbar bis 1000 mbar reichen kann, mit einem Schutzgas gefüllt wurde.

8. Verfahren nach einem der Ansprüche 3 bis 7, **dadurch gekennzeichnet, dass** eine Relativbewegung zwischen dem Target und dem Plasma bewirkt wird.

9. Verfahren nach einem der Ansprüche 3 bis 8, **dadurch gekennzeichnet, dass** vor dem Abscheiden der Verbindung eine Oberflächenbehandlung des Targets durchgeführt wird.

10. Verfahren nach Anspruch 9, **dadurch gekennzeichnet, dass** die Oberflächenbehandlung ein Reinigen des Oberflächenabschnitts des Targets umfasst.

11. Verfahren nach Anspruch 9, **dadurch gekennzeichnet, dass** die Oberflächenbehandlung ein Abscheiden einer Schicht aus einem Haftmaterial im Bereich des Oberflächenabschnitts des Targets umfasst.

12. Verfahren nach einem der Ansprüche 3 bis 11, **dadurch gekennzeichnet, dass** eine Wärmeregulierung des Oberflächenabschnitts des Targets während des Plasmaspritzens der Verbindung vollzogen wird.

13. Verfahren nach einem der Ansprüche 3 bis 12, **dadurch gekennzeichnet, dass** mehrere Einspritzkanäle verwendet werden, für die die Einspritzparameter in Abhängigkeit der in jeden Kanal eingespritzten Materialien unabhängig voneinander eingestellt werden.

14. Target einer Vorrichtung zur Kathodenzerstäubung, insbesondere magnetfeldunterstützten, wobei das Target die Zusammensetzung nach einem der Ansprüche 1 oder 2 aufweist.

15. Target nach Anspruch 14, **dadurch gekennzeichnet, dass** es eine flächige oder rohrförmige Geometrie aufweist.

16. Target nach einem der Ansprüche 14 oder 15, **dadurch gekennzeichnet, dass** es auf der Basis eines Trägermaterials aus Kupfer oder Kupferlegierung ist.

17. Target nach Anspruch 16, **dadurch gekennzeichnet, dass** das Target mit einer Haftschicht auf Basis einer Kupferlegierung beschichtet ist.

18. Target nach einem der Ansprüche 14 oder 15, **dadurch gekennzeichnet, dass** es auf der Basis eines Trägermaterials aus rostfreiem Stahl ist.

19. Target nach Anspruch 18, **dadurch gekennzeichnet, dass** das Target mit einer Haftschicht auf Basis einer Nickellegierung beschichtet ist.
